# EUROPEAN PATENT APPLICATION

(11) **EP 1 505 637 A1**
(43) Date of publication of application: **09.02.2005**
(21) Application number: 02807402.9
(22) Date of filing: 11.10.2002
(51) Int. Cl.: H01L 21/02, H01L 21/68, F24F 7/06, F24F 9/00

(54) **SEMICONDUCTOR MANUFACTURING APPARATUS OF MINIENVIRONMENT SYSTEM**

(30) Priority: 10.05.2002 JP 2002135222
(71) Applicant: Kondoh Industries Ltd., Tokyo 105-0001 (JP); Cambridge Filter Japan, Ltd., Tokyo 105-0001 (JP)
(72) Inventor: KISAKIBARU, Toshirou, Cambridge Filter Japan, Ltd., Tokyo 105-0001 (JP)
(74) Representative: von Hellfeld, Axel, Dr. Dipl.-Phys.
(86) International application number: PCT/JP2002/010584
(87) International publication number: WO 2003/096395

(57) **Abstract**

A semiconductor manufacturing device (76) of a minienvironment system, in which system a wafer (73) is conveyed by a wafer hermetic container (71) to the semiconductor manufacturing device equipped with a wafer carrying-in opening (98), comprising a clean-air injection semiconductor manufacturing device (1) for forming a clean-air curtain between an opened opening (74) of the hermetic container and the wafer carrying-in opening to prevent ambient air from entering the opened opening (74) of the hermetic container when the hermetic container (71), which is located in front of the wafer carrying-in opening of the semiconductor manufacturing, is opened.

## Description

### Field of the Invention

This invention relates to a semiconductor manufacturing device of a minienvironment system used in a clean room for producing semiconductors. In particular, this invention relates to a semiconductor manufacturing device having a clean-air injection device at its wafer carrying-in opening for preventing ambient air from entering a wafer hermit device when a wafer is transferred between the hermit device and the semiconductor manufacturing device.

### Description of the Prior Art

Conventionally, in a clean room for producing semiconductors, a minienvironment system is adapted, where wafers are transferred and handled in a hermit container to reduce investment and save energy. Recently, to obtain many semiconductor chips from a single wafer, a wafer of the size of 300 mm in diameter has become to be used.

In the minienvironment system of the 300 mm diameter wafer generation, a specification for a hermetic container to accommodate wafers and a specification for a loading portion that transfers the wafers from the hermetic container into a semiconductor manufacturing device and from it into the hermetic container are international standards.

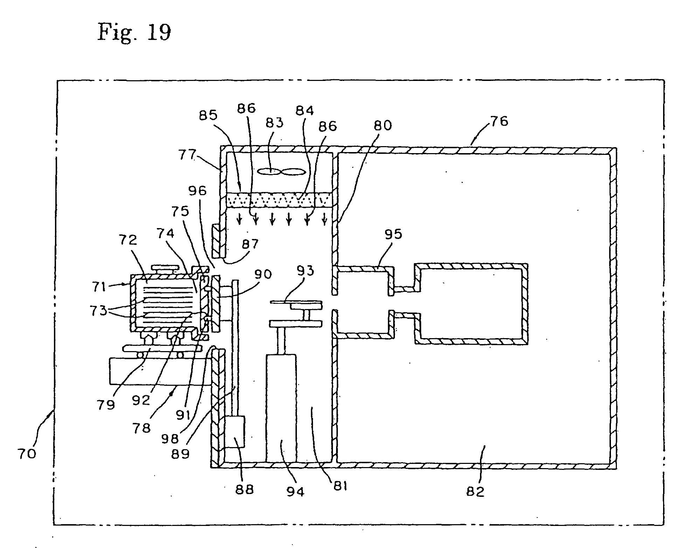

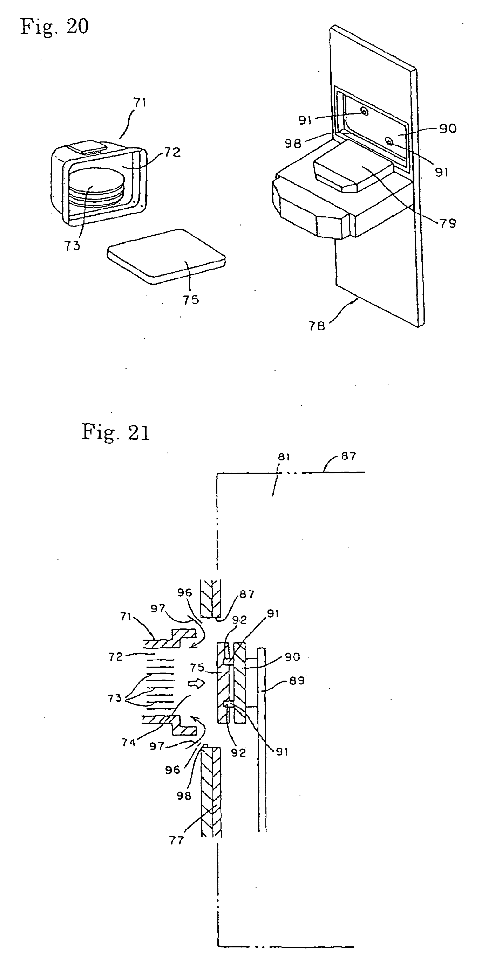

A conventional semiconductor manufacturing device of the minienvironment system, which is installed in a clean room 70, is configured as shown in Figs. 19 and 20. Fig. 19 is a schematic cross-sectional view of the conventional semiconductor manufacturing device of the minienvironment system, and Fig. 20 is an exploded perspective view of a hermetic container and a loading device. The hermetic container 71 accommodates wafers 73, which are vertically arranged in it, at its accommodating portion 72. The hermetic container 71 can be closed by closing an exit/entrance 74 for the wafers 73 by a cover 75 and is placed on a movable table 79, which can be moved to and away from a loading portion 78 securely attached to a front panel 77 of the semiconductor manufacturing device 76.

The semiconductor manufacturing device 76 is divided into two spaces by a separating wall 80 located at the center of the device 76, namely, a front, high cleanliness space 81 and a rear, low cleanliness space 82.

A fan filter unit 85, comprising a fan 83 and a filter 84, is installed at a ceiling of the high cleanliness space 81, and clean air 86 is supplied to the high cleanliness space 81, keeping there a high cleanliness atmosphere.

An opening 87 is formed in the front panel 77 of the high cleanliness space 81 (which panel 77 constitutes the semiconductor manufacturing device 76) at a position that faces the cover 75 of the hermetic container 71, so that the opening 87 is connected to an opening 98 of the loading portion 78 to act as a passage for the wafers 73 when they are drawn out from the hermetic container 71 into the high cleanliness space 81 or when they are placed in the hermetic container 71.

An electric motor 88 is fixedly mounted on the inner, lower surface of the front panel 77 and is connected to an opening/closing arm 89 through a speed reducer (not shown) to move the arm 89 vertically and forwardly and backwardly. A plate 90 is fixedly mounted on the opening/closing arm 89 at its upper end located at the opening 87 so as to engage with and then open or close the cover 75. The number 91 denotes engaging projections formed on the plate 90, for engaging with corresponding receiving portions 92 formed on the cover 75 so as to secure the plate 90 to the cover 75.

Further, a robot 94 is also installed in the high cleanliness space 81. The robot is provided with an arm 93 at its upper part for drawing a wafer 73 from the hermetic container 71 into the high cleanliness space 81 or inserting the wafer into the hermetic container 71. A wafer 73 is drawn into the high cleanliness space 81 by the arm 93 and is then transferred by the robot 95 to a chamber 95 located in the low cleanliness space 82 and is the processed in the chamber 95. The processed wafer 73 is moved onto the arm 93 and then placed in the hermetic container 71.

In operation, to draw a wafer 73 from the hermetic container 71 onto the arm 93, the electric motor 88 is operated first to forward the opening/closing arm 89 to engage the engaging projections 91 of the plate 90 with the receiving portions 92 of the cover 75 of the hermetic container 71, so that the plate 90 and the cover 75 are secured together. The opening/closing arm 89 is then moved back to draw the cover 75 together with the plate 90 into the high cleanliness space 81, to open the container 71. The opening/closing arm 89 is then lowered to open the openings 87 and 98, and the operation of the electric motor 88 is then stopped.

The robot 94 is then operated to move the arm 93 through the openings 87 and 98 until the arm 93 is located under a wafer 73, which is now to be transferred. The wafer 73 is carried on the arm 93 and drawn by it from the hermetic container 71 into the high cleanliness space 81 of the semiconductor manufacturing device 76 and is further moved into the chamber 95 of the low cleanliness space 81 of the semiconductor manufacturing device 76 by the robot 94 for being processed in the chamber 95.

The wafer 73, which has been drawn into the high cleanliness space 81 and into the chamber 95 and processed therein, is placed on the arm 93 by operating the robot 94 and passed through the openings 87, 98 and the opened entrance/exit 74 into the hermetic container 71.

By repeating the operation, all the wafers 73 are in turn carried into the semiconductor manufacturing device 76 and processed there. When the process has been completed for all the wafers 73 in the hermetic container 71, the electric motor 88 is operated to raise and then forward the opening/closing arm 89 to attach the cover 75, which is secured to the plate 90 of the opening/closing arm 89, to the entrance/exit 74 of the hermetic container 71. By disengaging the engaging projections 91 from the receiving portions 92, the hermetic container 71 is closed.

However, in the hermetic container 71 and the loading portion 78 specified by the conventional standards, the pressure in the hermetic container 71 temporarily becomes lower than that of the ambient air (namely, low cleanliness air supplied to the clean room 70 located outside the semiconductor manufacturing device 76) when the cover 75 of the hermetic container 71 located at the loading portion 78 is opened and moved into the high cleanliness space 81 of the semiconductor manufacturing device 7 by the opening/closing arm 89. Thus, since the amount and the pressure of the air flow from the fan filter unit 85 is not enough, the ambient air 97 passes through a gap 96 between the entrance/exit 74 of the hermetic container 71 and the opening 98 of the loading portion 78 and enters the container 71 as shown by arrows in Figure 21. This causes a problem in that the ambient air entrains dust in the container 71 in which it adheres to the wafers 73.

The present invention has been conceived in view of that problem. The purpose of the invention is to provide a semiconductor manufacturing device of a minienvironment system wherein an air curtain is formed around the periphery of an opening of the loading portion attached to the front panel of the semiconductor manufacturing device, which opening acts as the passage for the wafer, by proving a clean-air injection device for injecting clean air at the gap between the opening and the wafer entrance/exit of the hermetic container, preventing dust-entraining ambient air from passing through the gap so that the dust does not adhere to the wafers in the hermetic container.

### Summary of the Invention

The present invention is directed to a semiconductor manufacturing device of a minienvironment system for drawing a wafer contained in a hermetic container from it into the semiconductor manufacturing device and placing the wafer processed in the semiconductor manufacturing device into the hermetic container, wherein to solve the problem discussed above an air curtain is formed at a gap between an entrance/exit of the hermetic container through which the wafer is drawn out or entered into the container and an opening of a loading portion attached to the semiconductor manufacturing device by injecting clean air from a clean-air injection device connected to an air supplying device through a flexible tube, preventing ambient air from passing through the gap between the an entrance/exit of the hermetic container and the opening of the loading portion attached to the semiconductor manufacturing device and from entering the hermetic container.

### Brief Description of the Drawings

Fig. 1 is a schematic cross-sectional view of the first embodiment of the semiconductor manufacturing device of a minienvironment system of the present invention.
Fig. 2 is a schematic perspective view of a clean-air injection device and an air supply device of the semiconductor manufacturing device of Fig. 1.
Fig. 3 is a schematic cross-sectional view of the main part of the semiconductor manufacturing device of Fig. 1
Fig. 4 is a perspective view of the clean-air injection device of the semiconductor manufacturing device of Fig. 1.
Fig. 5 is a perspective view of the injection part that makes up the clean-air injection device of the semiconductor manufacturing device of Fig. 1.
Fig. 6 is an exploded view of the injection part that makes up the clean-air injection device of the semiconductor manufacturing device of Fig. 1.
Fig. 7 is a cross-sectional view of the injection part that makes up the clean-air injection device of the semiconductor manufacturing device of Fig. 1.
Fig. 8 is a perspective view of a guide cover that makes up the clean-air injection device of the semiconductor manufacturing device of Fig. 1.
Fig. 9 is a front view of the clean-air injection device of the semiconductor manufacturing device of Fig. 1.
Fig. 10 is a cross-sectional view of the clean-air injection device of the semiconductor manufacturing device of Fig. 1.
Fig. 11 is a perspective view of a clean-air injection device of the second embodiment of the semiconductor manufacturing device of a minienvironment system of the present invention.
Fig. 12 is a cross-sectional view of the clean-air injection device of Fig. 11.
Fig. 13 is a schematic and partly cross-sectional perspective view of a clean-air injection device and an air supplying device of the third embodiment of the semiconductor manufacturing device of the present invention.
Fig. 14 is a cross-sectional view of the clean-air injection device of Fig. 13.
Fig. 15 is a schematic and partly cross-sectional perspective view of a clean-air injection device and an air supplying device of the fourth embodiment of the semiconductor manufacturing device of the present invention.
Fig. 16 is a cross-sectional view of the clean-air injection device of Fig. 15.
Fig. 17 is a front view of another example of the air injection part that make up the clean-air injection device of the semiconductor manufacturing device of a semienvironment system of the present invention.
Fig. 18 is a further example of the air injection part that make up the clean-air injection device of the semiconductor manufacturing device of a semienvironment system of the present invention.
Fig. 19 is a schematic cross-sectional view of a semiconductor manufacturing device of a semienvironment system of the prior-art.
Fig. 20 is an exploded view of an airtight container and a loading device of the semiconductor manufacturing device of a semienvironment system of the prior-art.
Fig. 21 is a schematic cross-sectional view of the main part of the semiconductor manufacturing device of a semienvironment system of the prior-art.

### Description of the Preferred Embodiments

The embodiments of the present invention are now explained with reference to the accompanying drawings, wherein the same reference numbers are used for the elements that are also used in the conventional semiconductor device discussed above, and explanations for the structure and the function of those elements are omitted.

The semiconductor manufacturing device of a minienvironment system of the present invention is configured such that a clean-air injection device 1 is provided around the periphery of an opening 98 of a loading portion 78 of the conventional semiconductor manufacturing device 76, which opening 98 is opened to act as a passage for drawing a wafer 73 contained in a hermetic container 71 from it into a high cleanliness space 81 and for placing the wafer 73 from the semiconductor manufacturing device 76 into the hermetic container 71, and such that clean air is injected from the clean-air injection device 1 outwardly at the outer periphery of the opening 98 to form an air curtain between the entrance/exit 74 of the hermetic container 71 and the opening 98, preventing the dust-entraining ambient air in the clean room from passing through the gap 96 between the entrance/exit 74 of the hermetic container 71 and the opening 98 and from entering the hermetic container, thereby preventing the dust from entering the hermetic containers 71, i.e., preventing the dust from adhering to the wafers 73.

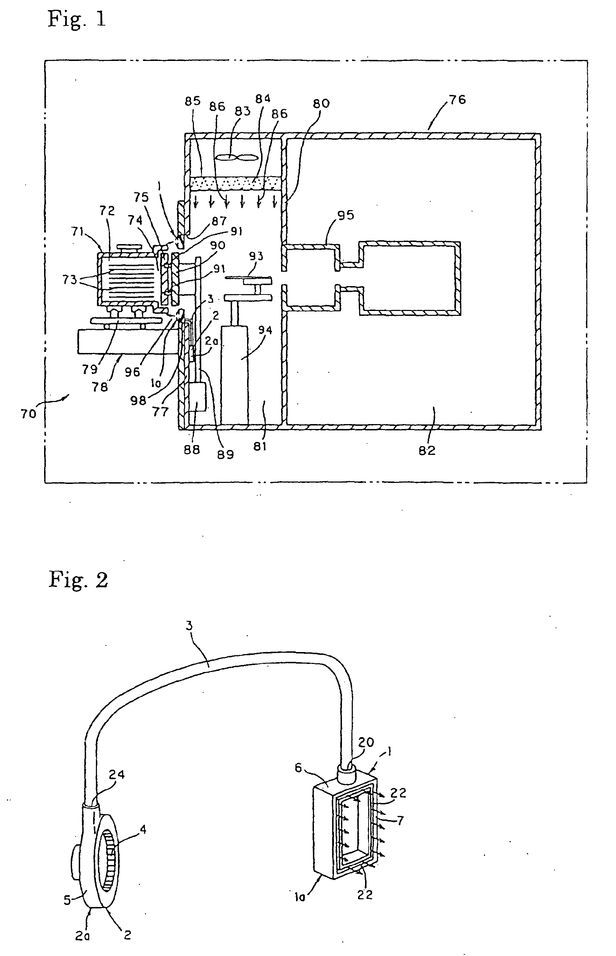

Figure 1 is a schematic cross-sectional view of the first embodiment of the semiconductor manufacturing device of a minienvironment system of the present invention. A loading portion 78, disposed in the clean room 70 in Figure 1, of the semiconductor manufacturing device is one that is specified by a world standard specification. A clean-air injection device 1a and an air supplying device 2a are disposed in a limited zone of the high cleanliness space 81 of the semiconductor manufacturing device 76 specified by the world standard specification.

The clean-air injection device 1a is connected to the air supplying device 2a through a flexible tube 3 as shown in Figure 2 (this is a schematic perspective view), so that the clean-air injection device 1a and the air supplying device 2a are separately disposed within the limited zone of the semiconductor manufacturing device 76.

The clean-air injection device 1a is formed as a thin frame and is secured to the periphery of the opening 98 of the loading portion 78 so as not to disturb the vertical and lateral motion of the plate 90, and the air supplying device 2a is formed as a thin body so as not to disturb the motion of both the electric motor 88 and the opening/closing arm 89 and is secured to the inner surface of the front panel 77 at a position spaced apart from the electric motor 88.

Since the air supplying device 2a should be thin, it has an annular inspiring portion 5 having a sirocco fan 4, as in Figure 2, for inspiring the clean air in the high cleanliness space 81 and for supplying it to the clean-air injection device 1a via the flexible tube 3.

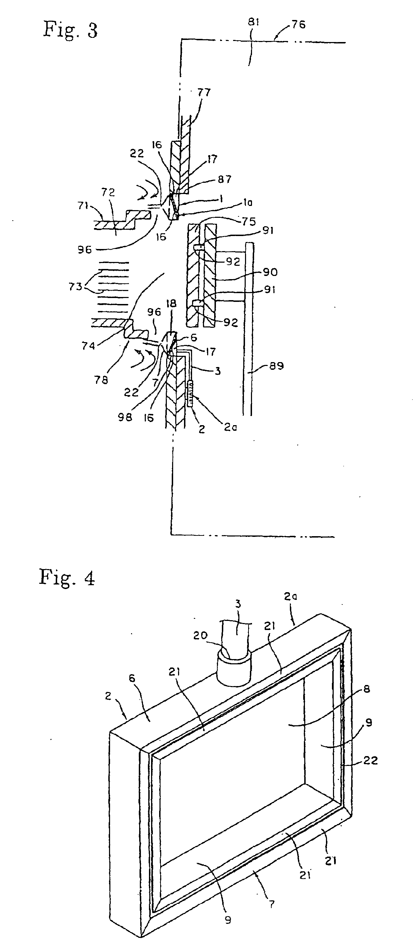

The clean-air injection device 1a is disposed around the periphery of the opening 98 of the loading portion secured to the front panel 77 of the semiconductor manufacturing device 76 as shown in Figure 3 so as to inject the clean air outwardly at the periphery of the opening 98. In this embodiment of the present invention the clean-air injection device 1a is shaped as, for example, a square frame that is adapted to the square opening 98.

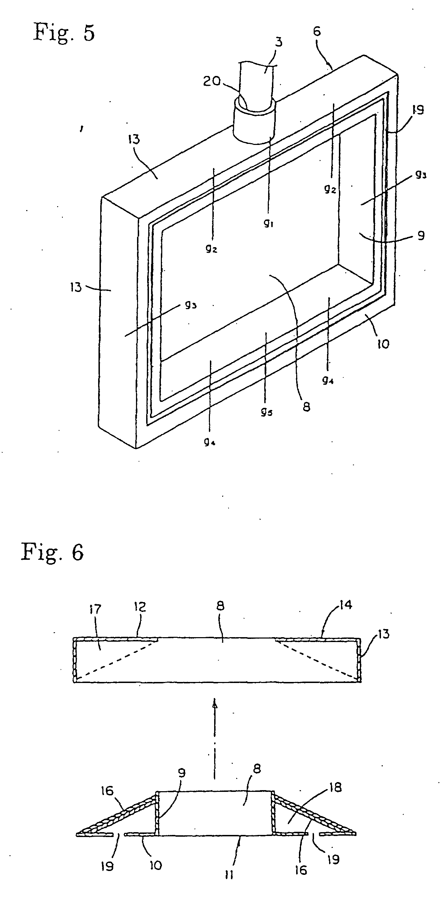

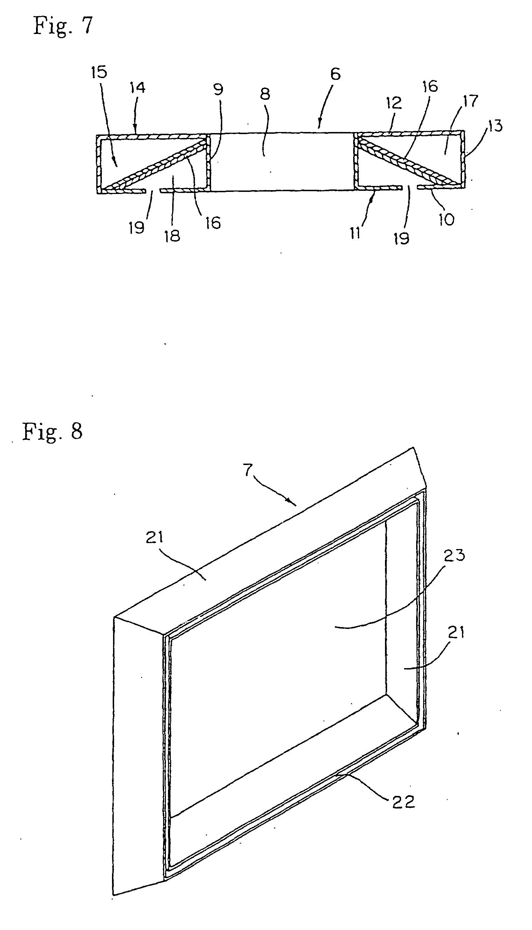

Referring to the clean-air injection device 1a in detail, it includes an injection portion 6 shaped as a frame and a guide cover (rectifying cover) 7 disposed in front of the injection portion 6. The injection portion 6 is manufactured by detachably mounting a front member 11 on a rear member 14 as shown in Figures 6 and 7, defining an annular air passage 15 between the front and rear member. The front member 11 is formed from an inner frame 9 made of an annular pate defining a space 8 therein that corresponds to the size of the opening 98, and a bottom plate 10 perpendicularly secured to the lower edge of the inner frame. The rear member 14 is formed from a top plate 12 defining a space 8 at it center that is similar to the space 8 of the front member 11, and an annular, outer peripheral wall plate 13 perpendicularly secured to the outer peripheral edge of the top plate 12. A filter (a stack of filters) 16 shaped as a truncated pyramid for removing dust is placed in the annular air passage 15, with its one end being placed on the upper peripheral edge portion of the inner plate 9 and the other being placed on the outer peripheral edge portion of the bottom plate 10 of the front member 11. The filter 16 divides the annular air passage 15 into two spaces that acts as passages, namely, an inflow-air passage 17 that is close to the top plate 12 and a clean-air passage 18 that is close to the bottom plate 10. An annular slit 19 for injecting a clean-air curtain is formed in the bottom plate 10.

As shown in Figure 5, the annular slit 19 is formed such that its width (g) is narrower at a part close to its inspiring port 20 opened to the outside of the injection portion, *i*.*e*., the width (g) of the part becomes larger as the part is located apart from the inspiring port 20, namely, g₁<g₂<g₃<g₄<g₅. Since the slit 19 is so formed, the pressure loss of the air that passes through the inflow-air passage 17 and the clean-air passage 18 is compensated, thereby allowing the clean air to be uniformly injected from all parts of the slit 19.

Further, as shown in Figure 8 an annular guide cover 7, which is a part of the clean-air injection device 1a and defines a space 23 within it, is placed in front of the injection portion 6. The guide cover 7 has two annular rectifying plates 21 that are spaced apart such that the spacing between them becomes less as they approaches to their front (or distal, or downstream) edges, defining an annular slit 22 therebetween at the edges, for rectifying the clean air from the slit 19 of the injection portion 6 and for uniforming the velocity distribution of the clean air.

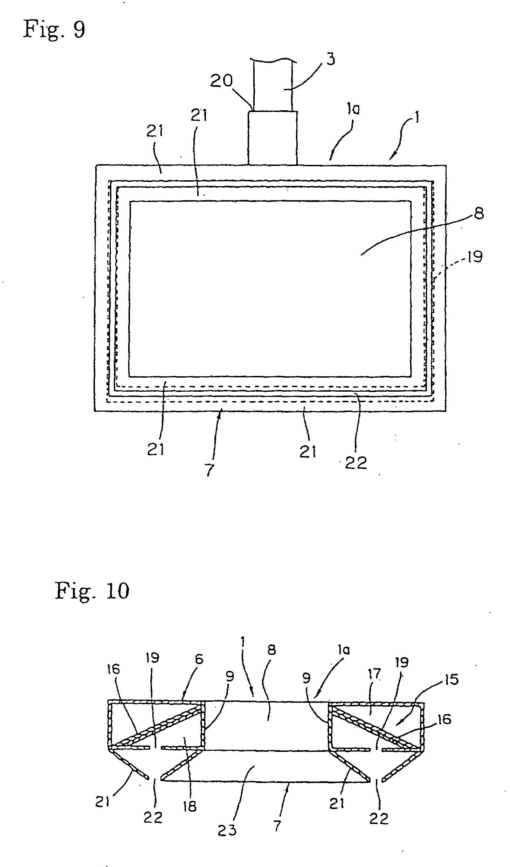

The guide cover 7, so arranged as discussed above, may be fixedly mounted on the front surface (the downstream side) of the injection portion 6, so that the clean-air injection device 1a is configured (Figures 9 and 10). Accordingly, clean air, the flow rate of which is adjusted and uniformed, is injected from the slit 19 of the injection portion 6 into the guide cover 7. The rectifying plates 21 then rectify the clean air in the guide cover 7, uniforms its velocity distribution, and allow the clean air to be injected from the guide slit 22 formed between the rectifying plates.

The clean-air injection device 1a, so arranged as discussed above, is fixedly mounted on the periphery of the opening 98 such that the guide slit 22 of the clean-air injection device 1a faces the gap 96 to be formed between the opening 98 and the entrance/exit 74 of the hermetic container 71. Further, by using the flexible tube 3, an air supply port 24 of the air supplying device 2 is connected to the air inspiring port 20 disposed at the inflow-air passage 17 side of the clean-air injection device 1a.

Since the filter 16, which is a part of the clean-air injection device 1a, is formed in the shape of a pyramid, its filtering surface area can be large, and hence the flow rate of the air per unit surface area of the filter can be small, reducing the pressure loss of the air. Further, since the front member 11 can be detached from the rear member 14 of the clean-air injection device 1a, the filter 16 can be readily changed just by removing the front member 11, without removing the entire clean-air injection device 1a from the front panel 77.

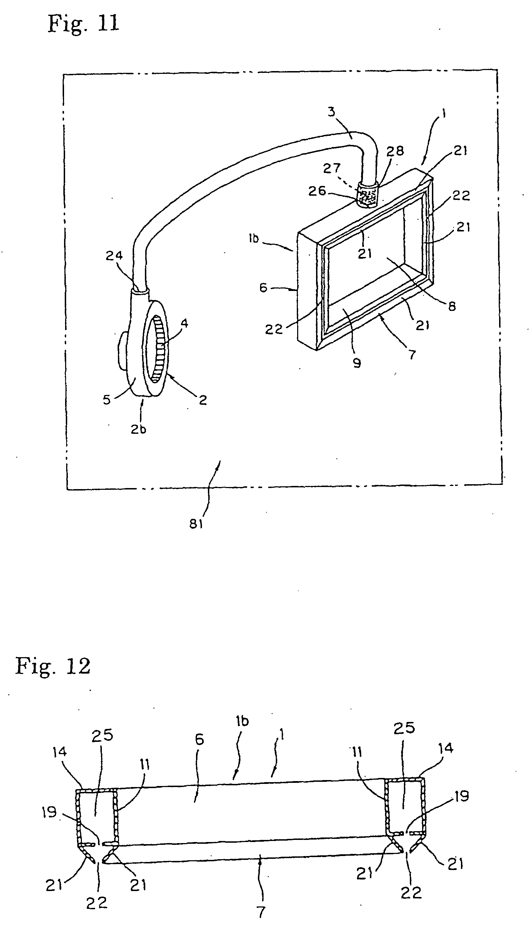

Figure 11 is a schematic perspective view, showing a clean-air injection device 1b and an air supplying device 2b of the second embodiment of the semiconductor manufacturing device of a minienvironment system of the present invention, and Figure 12 is a cross-sectional view of the clean-air injection device 1b. Although in the clean-air injection device 1a of the first embodiment the filter 16, which is shaped as a truncated pyramid, is placed in the air passage 15 to divide it into the inflow air passage 17 and the clean air passage 18, in this second embodiment of the present invention no filter is disposed in an air passage 25 formed between the front member 11 and the rear member 14.

That is, the entire air passage 25 formed between the front member 11 and the rear member 14 acts as a clean-air passage in the second embodiment of the present invention. A filter (a stack of filters) 27 for removing dust is disposed in a filtering vessel 28 detachably coupled to an inspiring port 26 of the clean-air injection device 1b, and air supply port 24 of the air supplying device 2b is connected to the filtering vessels 28 through a flexible tube 3. Both the clean-air injection device 1b and the air supplying device 2b are disposed in the high cleanliness space 81 of the semiconductor manufacturing device 76 the same as in the first embodiment. The air from the air supplying device 2b through the flexible tube 3 is purified by the filter 27, and the clean air is supplied through the inspiring port 26 into the air passage 25, then injected from the slit 19 of the injection portion 6 into the guide cover 7, and then injected from the guide slit 22 outwardly at the outer periphery of the opening 98. The filter 27 in the filtering vessel 28 can be changed with a new one by removing the filtering vessel 28. The filter acts the same as in the first embodiment, and thus the description for it is omitted.

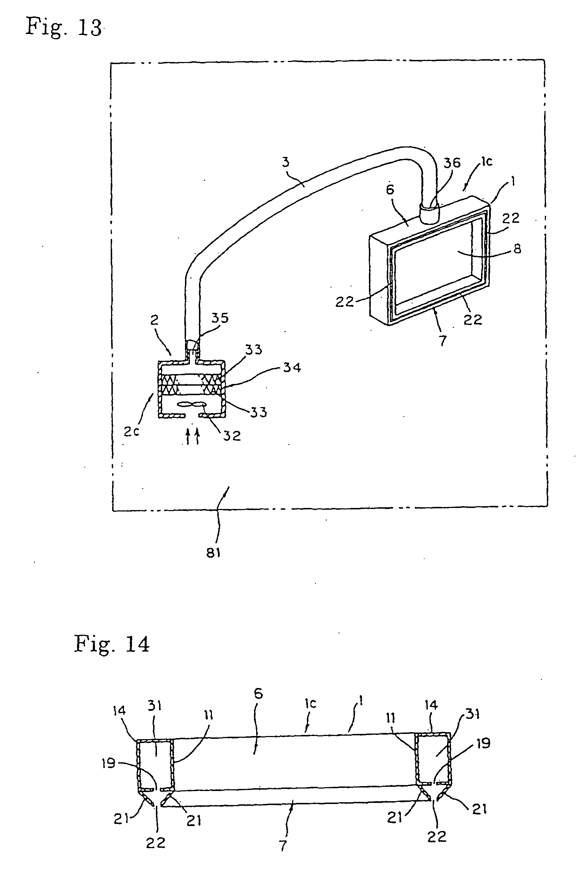

Figure 13 is a schematic perspective view partly in section, showing a clean-air injection device 1c and an air supplying device 2c of the third embodiment of the semiconductor manufacturing device of a minienvironment system of the present invention, and Figure 14 is a cross-sectional view of the clean-air injection device 1c.

In the first embodiment the clean-air injection device 1a includes the filter 16 shaped as a truncated pyramid and placed in the air passage 15 to divide it into the inflow air passage 17 and the clean air passage 18, and the air supplying device 2a has the sirocco fan 4. However, in the third embodiment of the present invention an entire air passage 31 formed between the front member 11 and the rear member 14 acts as a clean-air supplying passage the same as in the second embodiment, and the air supplying device 2c includes a small fan filter unit 34, comprising a fan 32 and a filter 33, disposed in the high cleanliness space 81 of the semiconductor manufacturing device. The air supply port 35 of the air supplying device 2c is connected to an inspiring port 36 of the clean-air injection device 1c by a flexible tube 3, and the clean-air injection device 1c and the air supplying device 2c are disposed in the high cleanliness space 81 of the semiconductor manufacturing device 76 the same as in the first embodiment.

The clean air in the high cleanliness space 81 is inspired and further purified by the small fan filter unit 34 of the third embodiment, and more clean air is supplied through the flexible tube 3 and through the inspiring port 36 into the air passage 31 and then injected from the slit 19 of the injection portion 6 into the guide cover 7 and then injected from it through the guide slit 22 outwardly at the outer periphery of the opening 98. The filter 33 in the small fan filter unit 34 can be readily changed with a new one. Since other functions in the third embodiment are the same as in the first embodiment, explanations for them are omitted.

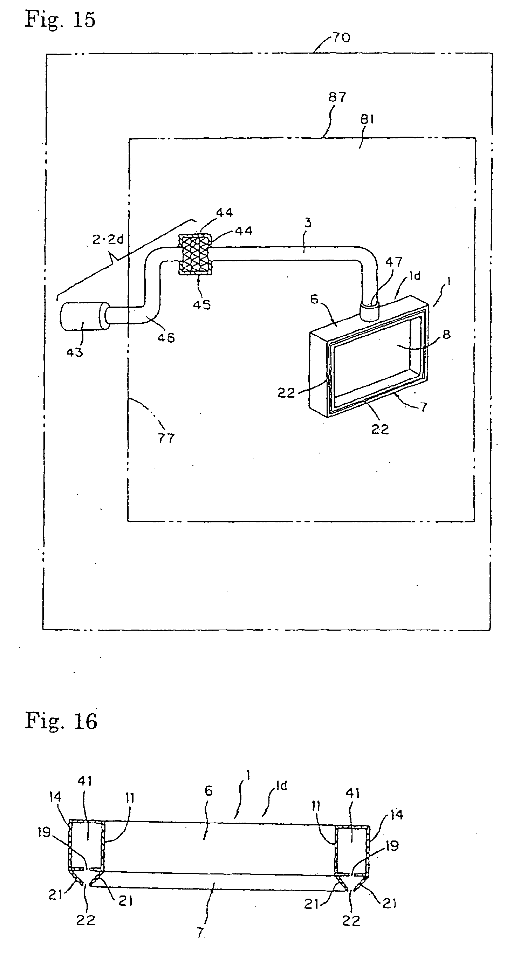

Figure 15 is a schematic perspective view partly in section, showing a clean-air injection device 1d and an air supplying device 2d of the fourth embodiment of the semiconductor manufacturing device of a minienvironment system of the present invention, and Figure 16 is a cross-sectional view of the clean-air injection device 1d. In the clean-air injection device 1d, an entire air passage 41, which is formed by the front member 11 and the rear member 14 the same in the second and third embodiments, acts as a clean-air supplying passage. An air compressor 43 is disposed in the clean room 70 located outside the semiconductor manufacturing device 76, for inspiring clean air supplied to the clean room 70 and supplying the clean air in the clean room to the clean-air injection device 1d. The air compressor 43 is connected, by a connecting tube 46, which passes through the front panel 77 of the semiconductor manufacturing device 76, to a filtering device 45 disposed in the high cleanliness space 81 of the semiconductor manufacturing device 76 and having a filter (a stack of filters) 44 for removing dust. The filtering device 45, which is a part of the clean-air injection device 1d, is connected to the inspiring port 47 of the clean-air injection device 1d via the flexible tube 3. The filtering device 45 and clean-air injection device 1d are disposed in the high cleanliness space 81 of the semiconductor manufacturing device 76 the same as in the first embodiment.

The low cleanliness air in the clean room 70 is inspired by the compressor 43 of the fourth embodiment and purified by the filtering device 45, and the purified, clean air is then supplied through the flexible tube 3 and through the inspiring port 47 into the air passage 41 and then injected from the slit 19 of the injection portion 6 into the guide cover 7 and then injected from its slit 22 outwardly at the outer periphery of the opening 98. The filter 44 of the filtering device 45 can be readily changed with a new one. Since the other functions of this embodiment are the same as in the first embodiment, the descriptions for them are omitted.

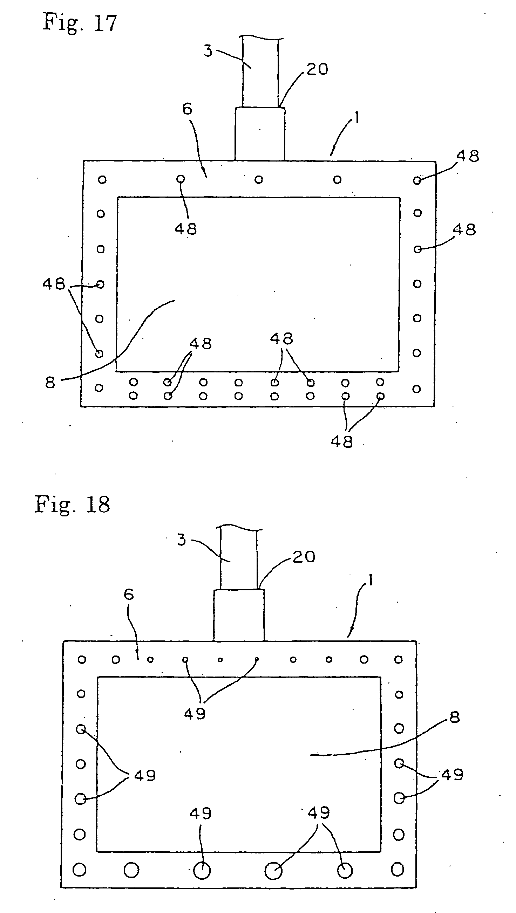

Figure 17 is a front view of another embodiment of the injection portion 6, which is a part of the clean-air injection device 1 of the present invention. Although the injection portion 6 of Figure 5 is formed with an annular single slit 19, the injection portion 6 of Figure 17 is formed with many injection apertures 48 of the same size, instead of the single slit 19. The injection apertures 48 are formed in the injection portion 6 such that their spacing is made less at the part of the injection portion that is close to the inspiring port 20, and such that the number of the apertures 48 is increased and their spacing is made great at the part as it is located away from the inspiring port 20. Further, a guide cover 7, which has the same structure as the guide cover 7 of Figures 8-10, is disposed in front of the injection portion 6 of Figure 17. Since the function of the injection portion 6 of Figure 17 is the same as that of Figure 5, the description for it is omitted. The injection portion 6 of Figure 17 may be used for any one of the clean-air injection devices 1a-1d.

Figure 18 is a front view of another embodiment of the injection portion 6, which is a part of the clean-air injection device 1 of the present invention. Although the injection portion 6 of Figure 5 is formed with a slit 19, an injection portion 6 of Figure 18 is formed with a plurality of apertures 49 having different diameters. That is, the aperture 49 located near an inspiring port 20 has a small diameter, and the diameter of the apertures becomes larger as they are located away from the inspiring port 20. Again, a cover 7, which is identical to the cover 7 of the previous embodiments, is disposed in front of the injection port 6. Since the function of the injection portion 6 of Figure 18 is the same as that of Figure 5, the description for it is omitted. The injection portion 6 of Figure 18 may be used for any one of the clean-air injection devices 1a-1d.

According to the embodiments of the present invention discussed above, an air curtain is formed at the gap 96 between the opening 98 and the entrance/exit 74 of the hermetic container 71 by injecting clean air from the slit 19 or the apertures 48 or 49 of the clean-air injection device 1, which is connected to the air supplying device 2 through the flexible tube 3, outwardly at the outer periphery of the opening 98 of the semiconductor manufacturing device 76 as shown in Figure 3 when the cover 7 of the hermetic container 71 is opened to the semiconductor manufacturing device 76 and a wafer73 is drawn onto the arm 93, or when the wafer is placed into the hermetic container 71, preventing the ambient air from entering the hermetic container 71 as shown in curved arrows. Thus no dust entrained in the ambient air adheres to the wafers 73 in the hermetic container 71.

Although several embodiments of the present invention are explained above, they are exemplary only, and the present invention is not limited to them. It will be understood by one skilled in the art that any changes and modifications can be made to them without departing from the spirit of the invention. Accordingly, the present invention is defined by the claims and includes the scope defined by the claims and its equivalents.

### Industrial Applicability

Since the present invention is so configured as explained above, an air curtain is formed at the gap between the entrance/exit of the hermetic container and the opening of the loading portion attached to the semiconductor manufacturing device by injecting clean air from the clean-air injection device, which is connected to the air supplying device through the flexible tube when a wafer73 is drawn from the hermetic container onto the arm, or when the processed wafer is placed into the hermetic container, preventing the ambient air from entering the hermetic container 71 from the gap to allow no dust to adhere to the wafers in the hermetic container.

## Claims

1. A semiconductor manufacturing device of the minienvironment system, in which system a wafer is conveyed by a wafer hermetic container to the semiconductor manufacturing device equipped with a wafer carrying-in opening, comprising a clean-air injection means for forming a clean-air curtain between an opened opening of the hermetic container and the wafer carrying-in opening to prevent ambient air from entering the opened opening of the hermetic container when the hermetic container, which is located in front of the wafer carrying-in opening of the semiconductor manufacturing, is opened.

2. The semiconductor manufacturing device of claim 1, wherein the clean-air injection means includes an annular, air injection portion attached to a periphery of the wafer carrying-in opening, an air supplying means, and a connecting tube for connecting the annular air-injection portion and the air supplying means in fluid communication, the air injection portion including an annular passage and at least one air injection port disposed along the annular passage, and wherein an open area of a part of the air injection port becomes larger as said part is located away from a junction of the connecting tube and the air injection portion along the annular passage.

3. The semiconductor manufacturing device of claim 2, wherein the at least one air injection port is a single annular slit, and an open area of a part of the slit becomes larger as said part is located away from the junction along the annular passage.

4. The semiconductor manufacturing device of claim 2, wherein at least one air injection port includes a plurality of apertures disposed along the annular passage, and the total open area of the apertures located at a part of the air injection port becomes larger as said part is located away from the junction along the annular passage.

5. The semiconductor manufacturing device of claim 2, wherein the connecting tube is a flexible tube, and the semiconductor manufacturing device has a high cleanliness space adjacent to the wafer carrying-in opening, and the air supplying means is disposed in the high cleanliness space for sending high cleanliness air from the high cleanliness space to the air injection portion.

6. The semiconductor manufacturing device of claim 2, wherein a filter is provided in at least one of the air injection portion, the connecting tube, and the air supplying means at an air passage from the air supplying means to the air injection port.

7. The semiconductor manufacturing device of claim 2 or 5, wherein the air supplying means includes a sirocco fan.

8. The semiconductor manufacturing device of claim 2, wherein the air supplying means includes a fan filter unit.

9. The semiconductor manufacturing device of claim 2, wherein the air injection portion includes a rear member, a front member detachably attached to the rear member for forming the annular passage with the rear member, and a filter for dividing a cross section of the annular passage into first and second areas such that the first area is in fluid communication with the connecting tube, while the second area is in fluid communication with the at least one air injection port, to allow the air from the air supplying means to enter the first area, pass through the filter into the second area, and then to be injected from the at least one air injection port.

10. The semiconductor manufacturing device of claim 2 or 9, wherein the annular air injection portion includes a rectifier cover disposed in front of the air injection portion to lead the air injected from the air injection port forwardly, the rectifier cover including a first frame and a second frame disposed inside the first frame for forming a rectifying passage to lead the clean air injected from the air injection port forwardly, and wherein the first and second frames are formed such that a width of the rectifying passage becomes narrower as the rectifying passage goes forward.
